# EUROPÄISCHE PATENTSCHRIFT

(11) **EP 3 464 169 B1**
(45) Veröffentlichungstag und Bekanntmachung des Hinweises auf die Patenterteilung: **24.02.2021**
(21) Anmeldenummer: 17729054.1
(22) Anmeldetag: 31.05.2017
(51) Int. Cl.: B81C 1/00

(54) **VERFAHREN ZUM EUTEKTISCHEN BONDEN VON WAFERN**
METHOD FOR EUTECTIC BONDING OF WAFERS
PROCÉDÉ DE LIAISON EUTECTIQUE DE PLAQUETTES

(30) Priorität: 07.06.2016 DE 102016210007
(43) Veröffentlichungstag der Anmeldung: 10.04.2019
(73) Patentinhaber: Robert Bosch GmbH, 70442 Stuttgart (DE)
(72) Erfinder: SCHMITZ, Volker, 72793 Pfullingen (DE); GROSSE, Axel, 72793 Pfullingen (DE)
(86) Internationale Anmeldenummer: PCT/EP2017/063220
(87) Internationale Veröffentlichungsnummer: WO 2017/211654

(56) Entgegenhaltungen:
- DE-A1-102009 026 628
- DE-A1-102014 210 852
- US-A1- 2006 208 326

## Beschreibung

### Stand der Technik

Die Erfindung betrifft ein Verfahren zum eutektischen Bonden von Wafern.

Bei MEMS-Inertialsensoren besteht die Konstruktion häufig aus einem Verbund zweier Wafer. Im üblichen Ansatz werden dabei ein Sensor- und ein Kappenwafer verwendet. Der Sensorwafer beinhaltet die empfindliche bewegliche Struktur und der Kappenwafer dient zu deren Schutz. Die Fügung wird mittels Waferbonden erreicht, z.B. in Form von Sealglasbonden oder eutektischem Bonden (z.B. Silizium/Gold oder Aluminium/Germanium). Dies erzeugt eine hermetische Verbindung, die die Einstellung einer gezielten Innenatmosphäre in einer von Sensorwafer und Kappenwafer umschlossenen Kaverne, welche den Sensorkern beinhaltet, ermöglicht.
Der Bondprozess erfolgt in einem eigens dafür vorgesehenen Gerät. Zuvor werden die beiden Wafer in einer gesonderten Justageeinheit zueinander justiert. Die beiden Wafer sind in einem sogenannten Bondtool fixiert, das dann auch in den Bonder eingelegt und erst nach Prozessende wieder vom Waferverbund gelöst wird. Üblich ist, dass die Waferoberflächen im Tool bereits Kontakt zueinander haben.
Im Prozess des eutektischen Bondens selbst gibt es im Wesentlichen folgende Stellgrößen:

### Temperatur

Nach Einladen der justierten Wafer in den Bonder wird eine definierte Temperatur-Rampe durchgefahren. Üblicherweise werden die beiden Wafer unterhalb des eutektischen Punktes erst auf gleichmäßige Temperatur gebracht (Vorphase), dann wird die Temperatur erhöht; es erfolgt das Durchlaufen des eutektischen Punktes (Hauptphase). Im letzten Schritt wird der Waferverbund abgekühlt.

### Gasdruck

Bevor die gewünschte Innenatmosphäre (z.B. ein Vakuum für Drehratensensoren) eingestellt wird, werden Spülzyklen durchgeführt. Damit werden Verunreinigungen z.B. der Bondkammer oder sonstige Reste von unerwünschten Stoffen ausgespült und abgepumpt.

### Anpresskraft

Die Anpresskraft dient neben der Temperatur dem eigentlichen Fügemechanismus des Bondens. Anpresskräfte beim Bonden können bis 100kN reichen. Die Kraft wird erst angelegt, wenn die entsprechende Starttemperatur erreicht und die gewünschte Innenatmosphäre sichergestellt ist.

Auf diese Weise sind gute Bondergebnisse zu erreichen. Kriterien für eine gute Bondverbindung sind minimale Aus- bzw. Abgasungen, reproduzierbare Bondverbindungen, (z.B. hinsichtlich Gefügebild und Stabilität) und Dichtheit (besonders relevant für Drehraten- und Beschleunigungssensoren). Es ist darauf zu achten, dass in der Vorphase die Temperaturen sicher unterhalb des eutektischen Punktes liegen.

In einer Ausgestaltung des eutektischen Bondens im Stand der Technik kommen auch Abstandshalter-Werkzeuge, "Flags" genannt, zur Anwendung, die sich zwischen den beiden Wafern befinden und im Bondprozess während der Vorphase ausgezogen werden. Dies wird beispielsweise in US 2006/208326 A1 beschrieben. Sie haben allerdings den Nachteil, dass beim Ausziehen der Flags ein zusätzlicher Versatz zwischen den Wafern, also eine nachträgliche Dejustierung, erzeugt werden kann.

Das oben beschriebene Bondverfahren im Stand der Technik hat außerdem den Nachteil, dass in der Vorphase eine klare Limitierung der Temperatur vorliegt. Zudem hat der von Beginn an anzutreffende Sachverhalt, dass die beiden Waferoberflächen und damit die beiden Bondpartner bereits in Kontakt sind, eine negative Auswirkung auf den Gasaustausch über den Wafer hinweg und unter Umständen auf homogene Oberflächenänderungen (z.B. Abgasungen von Wasser oder anderen Adsorbaten).

### Vorteile der Erfindung

Die Erfindung betrifft ein Verfahren zum eutektischen Bonden von Wafern mit den Schritten:
(a) Bereitstellen eines ersten Wafers mit einer ersten Bondschicht und eines zweiten Wafers mit einer zweiten Bondschicht und mit einem Abstandshalter, wobei der Abstandshalter dabei eine größere Schichtdicke als die zweite Bondschicht aufweist.
(b) Aneinanderlegen des ersten Wafers an den zweiten Wafer, wobei der Abstandshalter an der ersten Bondschicht anliegt, bei einer ersten Temperatur.
(c) Aneinanderpressen des ersten Wafers und des zweiten Wafers mit einer Anpresskraft bis zum Anliegen der ersten Bondschicht an der zweiten Bondschicht, wobei der Abstandshalter in die erste Bondschicht eindringt.
(d) Eutektisches Bonden des ersten Wafers mit dem zweiten Wafer durch Bilden eines Eutektikums wenigstens aus Teilen der ersten Bondschicht und der zweiten Bondschicht und somit Bilden eines Waferverbunds.

Eine vorteilhafte Ausgestaltung des erfindungsgemäßen Verfahrens sieht vor, dass nach dem Schritt (b) und vor dem Schritt (c) in einem Schritt (e) der erste Wafer und der zweite Wafer bei einer Temperatur nahe einer eutektischen Temperatur getempert werden.

Besonders vorteilhaft ist dabei, dass im Schritt (e) der erste Wafer und der zweite Wafer bei einer vierten Temperatur nahe der eutektischen Temperatur getempert werden, und anschließend der erste Wafer und der zweite Wafer auf eine fünfte Temperatur, welche unter der vierten Temperatur aber über der ersten Temperatur liegt, abgekühlt werden.

Besonders vorteilhaft ist in einer anderen Ausgestaltung, dass im Schritt (e) der erste Wafer und der zweite Wafer bei einer siebten Temperatur nahe der eutektischen Temperatur getempert und bis zu Schritt (d) auf der siebten Temperatur gehalten werden.

Eine vorteilhafte Ausgestaltung des erfindungsgemäßen Verfahrens sieht vor, dass im Schritt (a) der erste Wafer mit der ersten Bondschicht bereitgestellt wird, wobei die ersten Bondschicht in einem Bondbereich und in einem Stützbereich angeordnet ist, im Schritt (a) der zweite Wafer mit der zweiten Bondschicht bereitgestellt wird , wobei die zweite Bondschicht im Bondbereich und im Stützbereich angeordnet ist, wobei der Abstandshalter im Stützbereich angeordnet ist, im Schritt (c) das Aneinanderpressen des ersten Wafers und des zweiten Wafers bis zum Anliegen der ersten Bondschicht an der zweiten Bondschicht sowohl im Bondbereich als auch im Stützbereich erfolgt, und - im Schritt (d) das Eutektikum sowohl im Bondbereich als auch im Stützbereich gebildet wird und insbesondere der Abstandshalter in das Eutektikum einsinkt.

Eine vorteilhafte Ausgestaltung des erfindungsgemäßen Verfahrens sieht vor, dass im Schritt (a) der erste Wafer mit der ersten Bondschicht bereitgestellt wird, wobei die ersten Bondschicht in einem Bondbereich und in einem Stützbereich angeordnet ist, im Schritt (a) der zweite Wafer mit der zweiten Bondschicht bereitgestellt wird , wobei die zweite Bondschicht im Bondbereich angeordnet ist, wobei der Abstandshalter im Stützbereich angeordnet ist, im Schritt (c) das Aneinanderpressen des ersten Wafers und des zweiten Wafers bis zum Anliegen der ersten Bondschicht an der zweiten Bondschicht im Bondbereich erfolgt, im Schritt (d) das Eutektikum im Bondbereich gebildet wird und insbesondere der Abstandshalter in die erste Bondschicht eingepresst wird.

Die vorliegende Beschreibung offenbart auch einen eutektisch gebondeten Waferverbund mit einem ersten Wafer und einem zweiten Wafer welche mittels eines Eutektikums miteinander verbunden sind, dadurch gekennzeichnet, dass zwischen dem ersten Wafer und dem zweiten Wafer ein Abstandshalter angeordnet ist Dieser Waferverbund ist jedoch nicht Teil der Erfindung.

Eine vorteilhafte Ausgestaltung des eutektisch gebondeten Waferverbunds sieht vor, dass der Abstandshalter neben dem Eutektikum angeordnet ist oder von dem Eutektikum wenigstens teilweise unmittelbar umschlossen ist.

Eine vorteilhafte Ausgestaltung des eutektisch gebondeten Waferverbunds sieht vor, dass an dem ersten Wafer eine erste Bondschicht angeordnet ist und der Abstandshalter in die erste Bondschicht eingepresst ist.

Eine vorteilhafte Ausgestaltung des eutektisch gebondeten Waferverbunds sieht vor, dass der Abstandshalter eine größere Dicke als die erste Bondschicht aufweist.

Dabei wird auch eine mikromechanische Vorrichtung aufweisend einen eutektisch gebondeten Waferverbund wie vorstehend beschrieben offenbart.

Vorteile des erfindungsgemäßen Bondens mit internem Abstandshalter ggü. eutektischem Bonden mit Abstandshalter-Werkzeugen ("Flags") die später gezogen werden:
Vorteilhaft entfällt das Risiko der nachträglichen Dejustierung des ersten Wafers und des zweiten Wafers zueinander beim Ziehen der Abstandshalter-Werkzeuge. Vorteilhaft ist auch, dass die internen Abstandshalter toleranter gegenüber Wafer-Bow Unterschieden des ersten Wafers und des zweiten Wafers sind, als die Abstandshalter-Werkzeuge im Stand der Technik.

Vorteile des erfindungsgemäßen Bondens mit internem Abstandshalter, mit Tempern ggü. SdT eutektisch Bonden ohne Abstandshalter:
Mit Hilfe der vorliegenden Erfindung wird die Temperatur-Limitierung im SdT, d.h. dass die Temperatur in der Vorphase relativ weit unter dem eutektischen Punkt bleiben muss, aufgehoben und zudem die Zugänglichkeit zu den Waferoberflächen gesteigert. Hierdurch können die Oberflächen vor dem Bonden besser gereinigt werden. Damit werden spätere Aus- und Abgasungen in der fertigen Vorrichtung reduziert, d.h. es sind beispielsweise höhere Güten eines Drehratensensors erreichbar oder das Einstellen einer genau definierten Innenatmosphäre möglich, die wiederum zu niedrigeren Güte-Streuungen führen. Im Allgemeinen werden Verunreinigungen reduziert und ungewollte Effekte, die aus etwaigen Kontaminationen resultieren können vermieden oder stark reduziert.

Vorteilhaft ist, einen Abstandshalter, insbesondere aus einer strukturierten Oxidschicht zu verwenden, welcher die Auflagefläche zum Aluminium der ersten Bondschicht des Sensorwafers bildet. Das auf der Kappe befindliche Germanium der zweiten Bondschicht wird als dünnere Schicht abgeschieden, so dass ein Abstand zwischen den beiden Bondmaterialien Aluminium und Germanium entsteht. Der Abstandshalter wirkt so ähnlich wie ein Flag, das nicht ausgezogen werden muss. Im nachfolgenden Bondprozess wird beim Anlegen der Anpresskraft der Abstandshalter in das Aluminium gedrückt und dieses verdrängt, sodass bei Kontakt von Aluminium und Germanium bei entsprechender Temperatur das Eutektikum wie bisher erzeugt wird. Solange die Bondmaterialien auf Abstand gehalten werden, sind im justierten Zustand sogar Temperaturen über dem eutektischen Punkt möglich.

### Zeichnung

Figuren 1A - E zeigen ein Verfahren zum eutektischen Bonden von Wafern und einen Waferverbund im Stand der Technik.
Figuren 2A - F zeigen das erfindungsgemäße Verfahren zum eutektischen Bonden von Wafern in einem ersten Ausführungsbeispiel.
Figuren 3A - C zeigen im Vergleich Temperaturprofile beim eutektischen Bonden im Stand der Technik und im erfindungsgemäßen Verfahren.
Figuren 4A - C zeigen das erfindungsgemäße Verfahren zum eutektischen Bonden von Wafern in einem zweiten Ausführungsbeispiel.

### Beschreibung von Ausführungsbeispielen

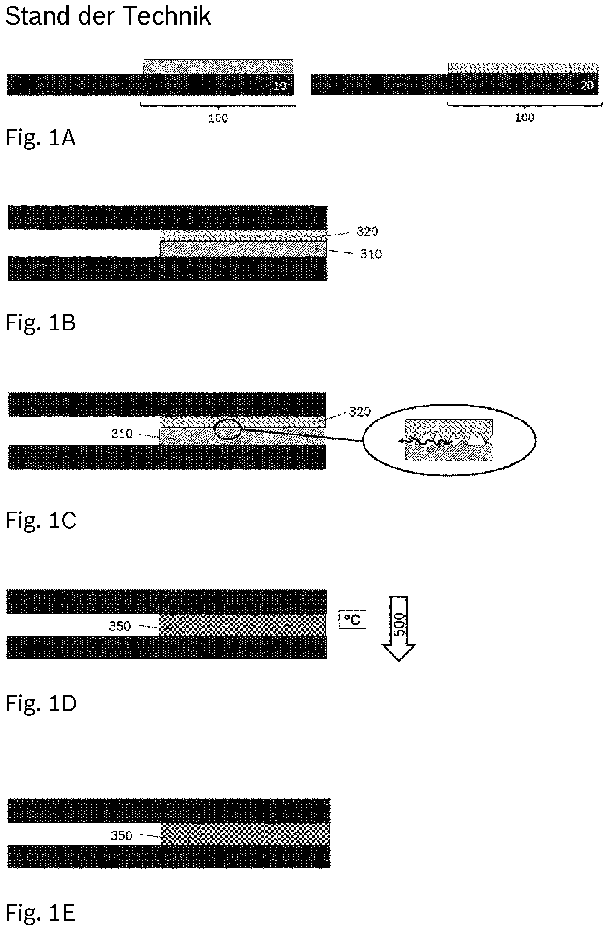

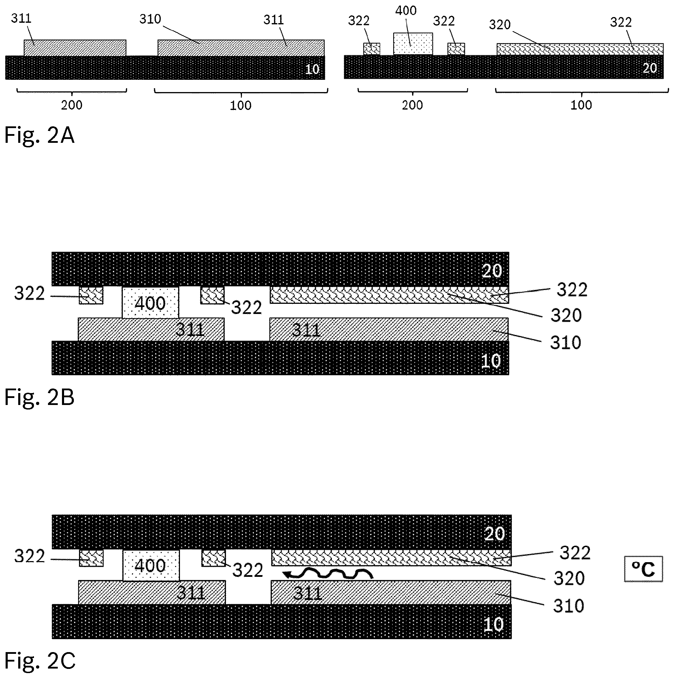

Die Figuren 1A-E und 2A und B zeigen ein Verfahren zum eutektischen Bonden von Wafern und einen Waferverbund im Stand der Technik.

Figur 1A zeigt schematisch das Bereitstellen eines ersten Wafers 10 und eines zweiten Wafers 20. Dabei weist der erste Wafer 10 in einem Bondbereich 100 eine erste Bondschicht 310 aus einem ersten Material 311 auf. Der zweite Wafer 20 weist in einem Bondbereich 100 eine zweite Bondschicht 320 aus einem zweiten Material 322 auf. Das erste Material 311 und das zweite Material 322 sind dabei derart gewählt, dass sie miteinander eine eutektische Legierung bilden können. Das erste Material 311 kann dabei beispielsweise Aluminium sein. Das zweite Material 322 ist dann beispielsweise Germanium.

Figur 1B zeigt schematisch in einem ersten Schritt das Anordnen des ersten Wafers 10 und des zweiten Wafers 20 zueinander. Der erste Wafer 10 und der zweite Wafer 20 werden in einer gesonderten Justageeinheit zueinander justiert und im fixierten Zustand, zum Beispiel in einem Bondtool geklemmt, in einen Bonder eingelegt. Üblich ist, dass die Waferoberflächen im Bondtool bereits Kontakt zueinander haben.

Figur 1C zeigt schematisch in einem zweiten Schritt die Vorphase des Bondens. Nach Einladen der justierten Wafer in den Bonder wird eine definierte Temperatur-Rampe durchgefahren. Üblicherweise werden die beiden Wafer unterhalb des eutektischen Punktes erst auf gleichmäßige Temperatur gebracht (Vorphase) Danach erfolgt das Durchfahren des Vorplateaus, wobei Gasaustausch über den Wafer durch rauhigkeitsbedingte Zwischenräume möglich ist. Dabei erfolgt kein Tempern über dem eutektischen Punkt.

Figur 1D zeigt schematisch in einem dritten Schritt die Hauptphase des Bondens, den eigentlichen eutektischen Bondvorgang.
Dabei erfolgt ein Anlegen der Anpresskraft und eine Anhebung der Temperatur über den eutektischen Punkt.

Figur 1E zeigt schematisch in einem vierten Schritt die Endphase des Bondens. Hier erfolgt eine Abkühlung und anschließend eine Ausschleusung der gebondeten Wafer.

Die Figuren 2A-F zeigen das erfindungsgemäße Verfahren zum eutektischen Bonden von Wafern in einem ersten Ausführungsbeispiel.

Figur 2A zeigt schematisch im ersten Ausführungsbeispiel des erfindungsgemäßen Verfahrens das Bereitstellen eines ersten Wafers 10 und eines zweiten Wafers 20. Dabei weist der erste Wafer 10 in einem Bondbereich 100 eine erste Bondschicht 310 aus einem ersten Bondmaterial 311 auf. Der zweite Wafer 20 weist in einem Bondbereich 100 eine zweite Bondschicht 320 aus einem zweiten Bondmaterial 322 auf. Das erste Bondmaterial 311 ist hier beispielsweise Aluminium. Das zweite Bondmaterial 322 ist dann beispielsweise Germanium. Im Unterschied zum oben beschriebenen Stand der Technik weisen der erste Wafer 10 und der zweite Wafer 20 jeweils einen Stützbereich 200 auf. Der erste Wafer 10 weist im Stützbereich 200 ebenfalls die erste Bondschicht 310 aus Aluminium auf. Der zweite Wafer 20 weist im Stützbereich 200 die zweite Bondschicht 320 aus Germanium sowie einen Abstandshalter 400 auf. Der Abstandshalter 400 ist dabei als eine auf dem zweiten Wafer 20 abgeschiedene oder erzeugte Schicht, beispielsweise aus einem Oxid, ausgeführt. Im vorliegenden Beispiel ist der Abstandshalter 400 aus thermischem Oxid erzeugt auf dem zweiten Wafer 20, hier einem Siliziumwafer. Der Abstandshalter 400 weist dabei eine größere Schichtdicke als die zweite Bondschicht 320 auf.
Der erste Wafer 10, hier ebenfalls ein Siliziumwafer, umfasst beispielsweise einen mikromechanischen Sensor nach Freistellung der MEMS-Struktur. Der zweite Wafer 20 ist beispielsweise eine Kappe für den mikromechanischen Sensor.

Figur 2B zeigt schematisch in einem ersten Schritt des erfindungsgemäßen Verfahrens das Anordnen des ersten Wafers 10 und des zweiten Wafers 20 zueinander. Der erste Wafer 10 und der zweite Wafer 20 werden in einer gesonderten Justageeinheit zueinander justiert und im fixierten Zustand, zum Beispiel in einem Bondtool geklemmt, in einen Bonder eingelegt. Der zweite Wafer 20 liegt dabei im Stützbereich 200 mit dem Abstandshalter 400 auf der ersten Bondschicht 310 des ersten Wafers 10 auf.

Figur 2C zeigt schematisch in einem zweiten Schritt des erfindungsgemäßen Verfahrens die Vorphase des Bondens. Im Bonder werden die zueinander justierten Wafer 10 und 20 ohne Anlegen einer Anpresskraft in der Vorphase getempert. Der durch den Abstandshalter 400 gewährleistete Abstand zwischen den Waferoberflächen verbessert Gasaustausch, Desoptions- oder Adsoptionseffekte. Temper-Temperaturen nahe oder über dem eutektischen Punkt sind möglich.

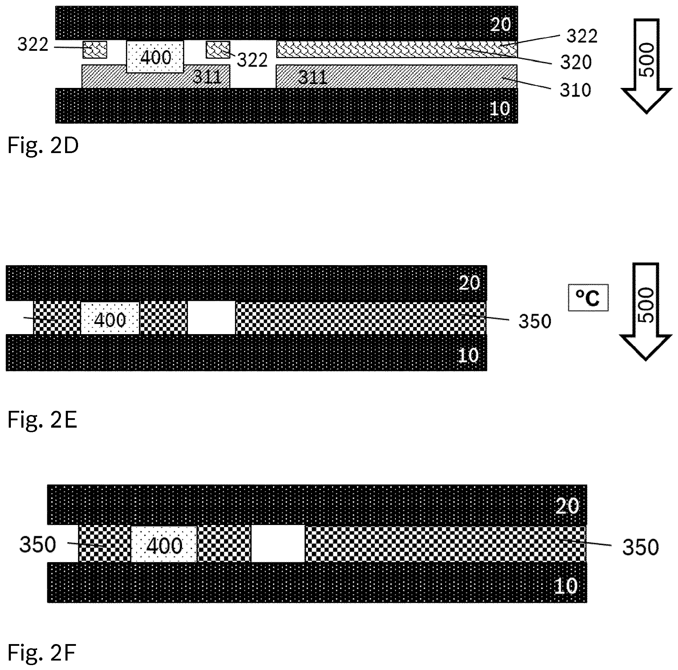

Figur 2D zeigt schematisch in einem dritten Schritt im ersten Ausführungsbeispiel des erfindungsgemäßen Verfahrens das Anlegen der Anpresskraft.
Nach dem Tempern erfolgt nun der eigentliche Bondprozess. Dabei sind erfindungsgemäß zwei Prozessvarianten a und b möglich.

### Variante a:

Zuerst wird, ohne den eutektischen Punkt zu überschreiten, bei einer Temperatur T5 die Anpresskraft 500 erhöht. Dabei wird der Abstandshalter 400 in das Aluminium der ersten Bondschicht 310 gequetscht. Aluminium ist bei den Temperaturen (>>300°C) sehr duktil. Andere geeignete duktile Materialien für das eutektische Bonden sind beispielsweise Gold und Zinn. Der Abstandshalter 400 sollte immer gegenüber dem weicheren Bondmaterial angeordnet sein. Der Abstandshalter 400 kann sich auf dem ersten Wafer 10 oder dem zweiten Wafer 20 befinden. Entsprechend muss die Position des weicheren Bond-Materials getauscht werden.

### Variante b:

Bei einer Temperatur T7 im Temperaturbereich nahe oder über dem eutektischen Punkt wird die Anpresskraft 500 angelegt. Damit erfolgt sofort bei Kontakt von Aluminium und Germanium die Bildung der Schmelze und ein direkter Übergang zum folgenden vierten Schritt.

Figur 2E zeigt schematisch in einem vierten Schritt im ersten Ausführungsbeispiel des erfindungsgemäßen Verfahrens die Temperaturerhöhung über den eutektischen Punkt und somit die Hauptphase des Bondens.
Bei Anliegen der Anpresskraft 500, welche den ersten Wafer 10 und den zweiten Wafer 20 aneinander presst, wird über den eutektischen Punkt temperiert. Sobald Aluminium und Germanium in Kontakt kommen, bildet sich eine Schmelze, das Eutektikum 350. Die Ausbildung einer Bondverbindung erfolgt wie im Stand der Technik bekannt. In dem hier beschriebenen ersten Ausführungsbeispiel des erfindungsgemäßen Verfahrens wird der Abstandhalter 400 dabei entsprechend mit Material der eutektische Legierung 350 umschlossen. Eventuell auftretender Stress baut sich ab.

Figur 2F zeigt schematisch in einem fünften Schritt des erfindungsgemäßen Verfahrens die Endphase des Bondens. Im fünften und letzten Schritt erfolgt die Abkühlung des Waferverbundes. Der Waferstack wird anschließend ausgeschleust und weiter verarbeitet.

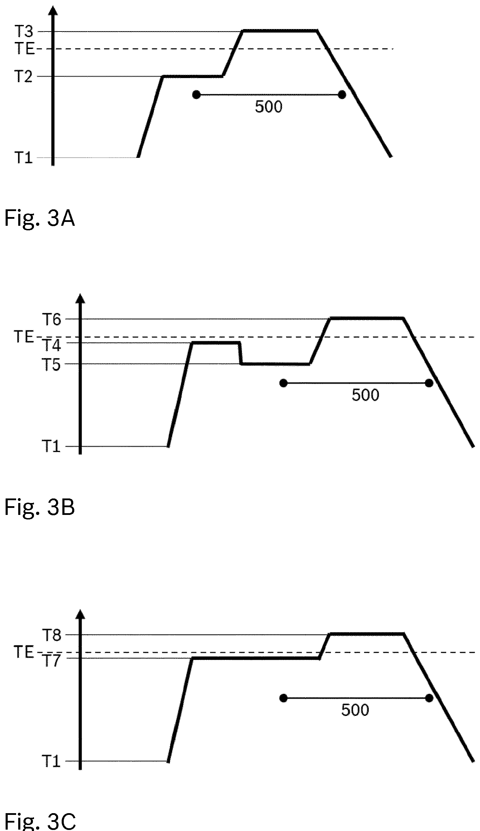

Die Figuren 3A - C zeigen im Vergleich Temperaturprofile beim eutektischen Bonden im Stand der Technik und im erfindungsgemäßen Verfahren. Schematisch dargestellt ist der Verlauf der Prozesstemperatur über der Zeit.

Figur 3A zeigt ein typisches Temperaturprofil für eutektisches Bonden im Stand der Technik. Dabei werden beide Wafer im justierten Zustand zunächst von einer ersten Temperatur T1 auf eine zweite Temperatur T2 erwärmt. Bei dieser zweiten Temperatur T2 durchlaufen die beiden Wafer eine Plateauphase. Die Vorphase bei Temperatur T2 dient zur Einstellung einer gleichmäßigen Temperierung der justierten Wafer. In dieser Phase erfolgt auch die
Einstellung der Innenatmosphäre. Anschließend werden die beiden Wafer bei einer angelegten Anpresskraft 500 über die eutektische Temperatur TE auf eine dritte Temperatur T3 erhitzt. Dabei kommt es zur Ausbildung der eutektischen Legierung und somit zur Ausbildung der eutektischen Bondverbindung. Anschließend wird der eutektisch gebondete Waferverbund abgekühlt.

Figur 3B zeigt das Temperaturprofil des erfindungsgemäßen Verfahrens zum eutektischen Bonden in Variante a mit Temperung. Dabei werden beide Wafer im justierten Zustand zunächst von einer ersten Temperatur T1 auf eine vierte Temperatur T4 nahe TE, das heißt bis auf wenige Kelvin unter oder über die eutektische Temperatur TE, erwärmt. Anschließend werden beide Wafer auf eine fünfte Temperatur T5, welche unter der vierten Temperatur T4 aber über der ersten Temperatur T1 liegt, abgekühlt. Der Vorphase ist also eine Temperung bei der vierten Temperatur T4 nahe oder über der eutektischen Temperatur TE vorgeschaltet. Temperatur T5 dient als Ausgangswert für den eigentlichen Bondvorgang. Beim Anlegen der Anpresskraft 500 erfolgt noch keine Bondung. Nachfolgend werden die beiden Wafer unter Anpressdruck auf eine sechste Temperatur T6, welche über der eutektische Temperatur TE liegt, erhitzt. Dabei wird die eutektische Bondverbindung erzeugt. Anschließend wird der eutektisch gebondete Waferverbund abgekühlt.

Figur 3C zeigt das Temperaturprofil des erfindungsgemäßen Verfahrens zum eutektischen Bonden in Variante b mit Temperung. Dabei werden beide Wafer im justierten Zustand zunächst von einer ersten Temperatur T1 auf eine siebte Temperatur T7 nahe TE, das heißt bis auf wenige Kelvin unter oder über die eutektische Temperatur TE, erwärmt. Die Vorphase erfolgt bei der siebten Temperatur T7 nahe oder über der eutektischen Temperatur TE. Der eigentliche Bondvorgang schließt sich nahtlos an. Bei T7>TE entsteht sofort bei Anlegen der Anpresskraft 500 das Eutektikum und damit der Start der Bondung. Bei T7<TE bildet sich erst bei weiterer Erwärmung der beiden Wafer und Übergang zu einer achten Temperatur T8 das Eutektikum.

Beide Varianten a und b des erfindungsgemäßen Verfahrens gemäß Figuren 3B und 3C weisen eine kürzere Bondzeit, also eine kürzere Verfahrensdauer als das eutektische Bonden im Stand der Technik gemäß Figur 3A auf.

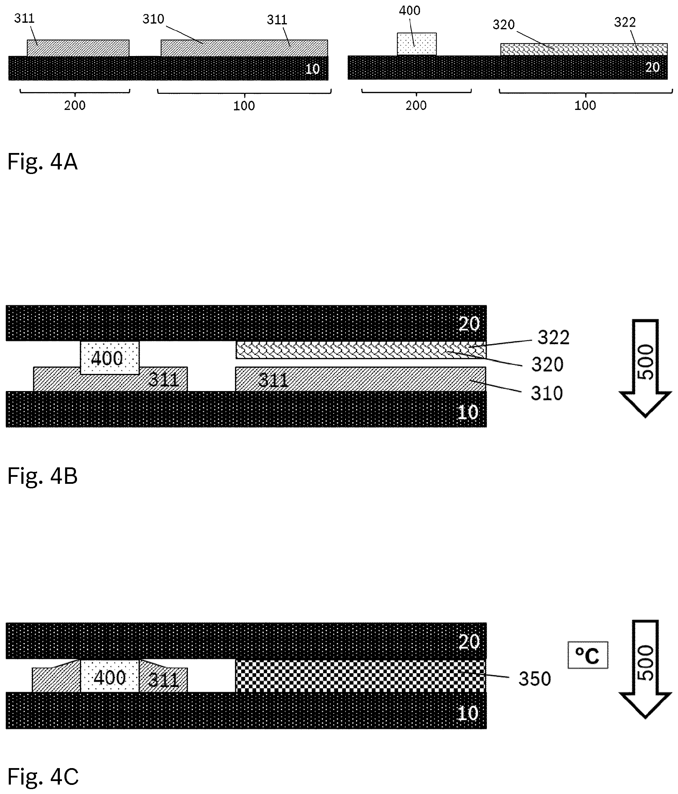

Die Figuren 4A-C zeigen das erfindungsgemäße Verfahren zum eutektischen Bonden von Wafern in einem zweiten Ausführungsbeispiel. Nachfolgend sind im Wesentlichen die Unterschiede zum ersten Ausführungsbeispiel beschrieben.

Figur 4A zeigt schematisch das Bereitstellen eines ersten Wafers 10 und eines zweiten Wafers 20. Dabei weist der erste Wafer 10 in einem Bondbereich 100 eine erste Bondschicht 310 aus einem ersten Bondmaterial 311 auf. Der zweite Wafer 20 weist in einem Bondbereich 100 eine zweite Bondschicht 320 aus einem zweiten Bondmaterial 322 auf. Das erste Bondmaterial 311 ist hier wieder beispielsweise Aluminium. Das zweite Bondmaterial 322 ist dann beispielsweise Germanium. Im Unterschied zum oben beschriebenen ersten Ausführungsbeispiel weisen der erste Wafer 10 und der zweite Wafer 20 jeweils einen Stützbereich 200 auf. Der erste Wafer 10 weist im Stützbereich 200 ebenfalls die erste Bondschicht 310 aus Aluminium auf. Im Unterschied zum oben beschriebenen ersten Ausführungsbeispiel weist der zweite Wafer 20 im Stützbereich 200 nur einen Abstandshalter 400 auf. Der Abstandshalter 400 ist dabei als eine auf dem zweiten Wafer 20 abgeschiedene oder erzeugte Schicht, beispielsweise aus einem Oxid, ausgeführt. Der Abstandshalter 400 weist dabei eine größere Schichtdicke als die zweite Bondschicht 320 auf.

Der erste Verfahrensschritt und der zweite Verfahrensschritt laufen analog zum ersten Ausführungsbeispiel gemäß den Figuren 2B und 2C ab.

Figur 4B zeigt schematisch im dritten Schritt das Anlegen der Anpresskraft. Die Anpresskraft 500 wirkt entlang des Pfeils.
Nach dem Tempern erfolgt der eigentliche Bondprozess. Dabei sind wieder zwei Prozessvarianten a und b möglich.

### Variante a:

Zuerst wird, ohne den eutektischen Punkt zu überschreiten, bei der fünften Temperatur T5 die Anpresskraft 500 erhöht. Das bewirkt, dass der Abstandshalter 400 in das Aluminium der ersten Bondschicht 310 gepresst wird. Das Aluminium wird dabei beiseite gedrückt. Aluminium ist bei den Temperaturen (>>300°C) sehr duktil. Schließlich kommen die erste Bondschicht 310 und die zweite Bondschicht 320 miteinander in Kontakt. Das Temperaturprofil entspricht dem in Figur 3B gezeigten.

### Variante b:

Bei der Temperatur T7 im Temperaturbereich nahe oder über dem eutektischen Punkt wird die Anpresskraft 500 angelegt. Damit erfolgt sofort bei Kontakt von Aluminium und Germanium die Bildung der Schmelze (siehe vierter Schritt), aber nicht im Bereich des Abstandshalters 400. Das Temperaturprofil entspricht dem in Figur 3C gezeigten.

Figur 4C zeigt schematisch im vierten Schritt die Temperaturerhöhung über den eutektischen Punkt und somit die Hauptphase des Bondens.
Bei Anliegen der Anpresskraft 500 wird über den eutektischen Punkt temperiert Sobald Aluminium und Germanium in Kontakt kommen, bildet sich die Schmelze, das Eutektikum 350. Der Bond erfolgt wie gewohnt, aber nicht im Bereich des Abstandshalters 400. Dort erfolgt eine Verdrängung des Aluminiums der ersten Bondschicht 310. Der Abstandshalter 400 wird von Aluminium umschlossen.

Im Anschluss erfolgt im fünften und letzten Schritt die Abkühlung des Waferverbundes.

Experimentell wurden folgende Schichtdicken getestet und verifiziert: erste Bondschicht 310 aus dem ersten Bondmaterial 311 Aluminium: 1,35µm, zweite Bondschicht 320 aus dem zweiten Bondmaterial 322 Germanium: 0,75µm, Abstandshalter 400: 1,6µm. Der Abstand zwischen den Bondmaterialien beträgt damit ca. 1µm. Im Prinzip kann er auch größer ausgeführt werden, allerdings sind die entsprechenden Bondpartner entsprechend anzugleichen. Zwei Ausführungsformen können unterschieden werden (beide im Experiment verifiziert):

### Reine Pressung

In diesem Fall wird der Abstandshalter 400 in das Aluminium der ersten Bondschicht 310 gedrückt. Die hohe Anpresskraft 500 sorgt dafür, dass die Verdrängung des Aluminiums so groß ist, dass eine gute Bondung erreicht wird.

### "Versinken" in Eutektikum

Hier erfolgt solange eine Verdrängung des Aluminiums durch Pressen bis das erste und das zweite Bondmaterial 311, 312 Kontakt zueinander haben. Sobald dieser Punkt erreicht ist, bildet sich bei entsprechender Temperatur um den Abstandshalter 400 ein Eutektikum, welches den Abstandshalter 400 umschließt und auftretenden Stress relaxiert. In diesem Fall reicht die Germaniumschicht dicht an den Abstandshalter 400, muss aber einen minimalen Abstand einhalten. Die Geometrie der Abstandshalter 400 ist flexibel. Es ist klar, dass die Abstandshalter-Oberfläche im Verhältnis zur Verdrängung steht und dies zu beachten ist. Eine regelmäßige Verteilung der Abstandshalter 400 auf dem Wafer ist anzustreben, um Waferbow-Effekten vorzubeugen. Eine Anordnung im Ritzgraben, also in Bereichen, in denen später der Waferverbund in einzelne Vorrichtungen zerteilt wird, erscheint aus Platzgründen sinnvoll.

Damit ergibt sich die Möglichkeit, komplexere Bondprozesse zu fahren. So kann die Vorphase mit Temperaturen nahe oder über dem eutektischen Punkt durchlaufen werden. Außerdem kann ein Spülen mit oberflächenreaktiven Gasen bzw. Chemikalien (z.B. zur Desorption, Adsorption oder Substitution von Komponenten dank des Abstandshalters wirksamer erfolgen.

Prinzipiell ist die Erfindung auch für andere Waferpaarungen vorstellbar, z.B. aus Sensor- und ASIC-Wafer ("ASIC als Kappe").

### Bezugszeichenliste

- 10: erster Wafer
- 20: zweiter Wafer
- 100: Bondbereich (Bondrahmen)
- 200: Stützbereich (Justagebereich)
- 310: erste Bondschicht (Al)
- 311: erstes Bondmaterial (Al)
- 320: zweite Bondschicht (Ge)
- 322: zweites Bondmaterial (Ge)
- 350: Eutektikum aus erstem und zweitem Bondmaterial (AlGe)
- 400: Abstandshalter
- 500: Anpresskraft
- T1: erste Temperatur
- T2: zweite Temperatur
- T3: dritte Temperatur
- T4: vierte Temperatur
- T5: fünfte Temperatur
- T6: sechste Temperatur
- T7: siebte Temperatur
- T8: achte Temperatur
- TE: eutektische Temperatur

## Patentansprüche

1. Verfahren zum eutektischen Bonden von Wafern mit den Schritten:
(a) Bereitstellen eines ersten Wafers (10) mit einer ersten Bondschicht (310) und eines zweiten Wafers (20) mit einer zweiten Bondschicht (320) und mit einem Abstandshalter (400), wobei der Abstandshalter (400) dabei eine größere Schichtdicke als die zweite Bondschicht (320) aufweist.
(b) Aneinanderlegen des ersten Wafers (10) an den zweiten Wafer (20), wobei der Abstandshalter (400) an der ersten Bondschicht (310) anliegt, bei einer ersten Temperatur (T1).
(c) Aneinanderpressen des ersten Wafers (10) und des zweiten Wafers (20) mit einer Anpresskraft (500) bis zum Anliegen der ersten Bondschicht (310) an der zweiten Bondschicht (320), wobei der Abstandshalter (400) in die erste Bondschicht (310) eindringt.
(d) Eutektisches Bonden des ersten Wafers (10) mit dem zweiten Wafer (20) durch Bilden eines Eutektikums (350) wenigstens aus Teilen der ersten Bondschicht (310) und der zweiten Bondschicht (320) und somit Bilden eines Waferverbunds.

2. Verfahren zum eutektischen Bonden von Wafern nach Anspruch 1, **dadurch gekennzeichnet, dass** nach dem Schritt (b) und vor dem Schritt (c) in einem Schritt (e) der erste Wafer (10) und der zweite Wafer (20) bei einer Temperatur (T4, T7) nahe einer eutektischen Temperatur (TE) getempert werden.

3. Verfahren zum eutektischen Bonden von Wafern nach Anspruch 2, **dadurch gekennzeichnet, dass**
- im Schritt (e) der erste Wafer (10) und der zweite Wafer (20) bei einer vierten Temperatur (T4) nahe der eutektischen Temperatur (TE) getempert werden, und
- anschließend der erste Wafer (10) und der zweite Wafer (20) auf eine fünfte Temperatur (T5), welche unter der vierten Temperatur (T4) aber über der ersten Temperatur (T1) liegt, abgekühlt werden.

4. Verfahren zum eutektischen Bonden von Wafern nach Anspruch 2, **dadurch gekennzeichnet, dass**
- im Schritt (e) der erste Wafer (10) und der zweite Wafer (20) bei einer siebten Temperatur (T7) nahe der eutektischen Temperatur (TE) getempert und bis zu Schritt (d) auf der siebten Temperatur (T7) gehalten werden.

5. Verfahren zum eutektischen Bonden von Wafern nach einem der vorhergehenden Ansprüche 1 bis 4, **dadurch gekennzeichnet, dass**
- im Schritt (a) der erste Wafer (10) mit der ersten Bondschicht (310) bereitgestellt wird, wobei die erste Bondschicht (310) in einem Bondbereich (100) und in einem Stützbereich (200) angeordnet ist;
- im Schritt (a) der zweite Wafer (20) mit der zweiten Bondschicht (320) bereitgestellt wird, wobei die zweite Bondschicht (320) im Bondbereich (100) und im Stützbereich (200) angeordnet ist, wobei der Abstandshalter (400) im Stützbereich angeordnet ist;
- im Schritt (c) das Aneinanderpressen des ersten Wafers (10) und des zweiten Wafers (20) bis zum Anliegen der ersten Bondschicht (310) an der zweiten Bondschicht (320) sowohl im Bondbereich (100) als auch im Stützbereich (200) erfolgt;
- im Schritt (d) das Eutektikum (350) sowohl im Bondbereich (100) als auch im Stützbereich (200) gebildet wird und insbesondere der Abstandshalter (400) in das Eutektikum (350) einsinkt.

6. Verfahren zum eutektischen Bonden von Wafern nach einem der vorhergehenden Ansprüche 1 bis 4, **dadurch gekennzeichnet, dass**
- im Schritt (a) der erste Wafer (10) mit der ersten Bondschicht (310) bereitgestellt wird, wobei die erste Bondschicht (310) in einem Bondbereich (100) und in einem Stützbereich (200) angeordnet ist;
- im Schritt (a) der zweite Wafer (20) mit der zweiten Bondschicht (320) bereitgestellt wird, wobei die zweite Bondschicht (320) im Bondbereich (100) angeordnet ist, wobei der Abstandshalter (400) im Stützbereich angeordnet ist;
- im Schritt (c) das Aneinanderpressen des ersten Wafers (10) und des zweiten Wafers (20) bis zum Anliegen der ersten Bondschicht (310) an der zweiten Bondschicht (320) im Bondbereich (100) erfolgt; und
- im Schritt (d) das Eutektikum (350) im Bondbereich (100) gebildet wird und insbesondere der Abstandshalter (400) in die erste Bondschicht (310) eingepresst wird.

## Claims

1. Method for eutectically bonding wafers, comprising the steps of:
(a) providing a first wafer (10) having a first bonding layer (310) and a second wafer (20) having a second bonding layer (320) and having a spacer (400), wherein the spacer (400) has a greater layer thickness than the second bonding layer (320) in this case,
(b) placing the first wafer (10) on the second wafer (20), wherein the spacer (400) rests on the first bonding layer (310), at a first temperature (T1),
(c) pressing the first wafer (10) and the second wafer (20) against one another with a contact-pressure force (500) until the first bonding layer (310) comes to rest on the second bonding layer (320), wherein the spacer (400) penetrates the first bonding layer (310),
(d) eutectically bonding the first wafer (10) to the second wafer (20) by forming a eutectic (350) at least from parts of the first bonding layer (310) and the second bonding layer (320) and in this way forming a wafer composite.

2. Method for eutectically bonding wafers according to Claim 1, **characterized in that**, after step (b) and before step (c), the first wafer (10) and the second wafer (20) are conditioned at a temperature (T4, T7) close to a eutectic temperature (TE) in a step (e).

3. Method for eutectically bonding wafers according to Claim 2, **characterized in that**
- the first wafer (10) and the second wafer (20) are conditioned at a fourth temperature (T4) close to the eutectic temperature (TE) in step (e), and
- then the first wafer (10) and the second wafer (20) are cooled down to a fifth temperature (T5) which lies below the fourth temperature (T4) but above the first temperature (T1).

4. Method for eutectically bonding wafers according to Claim 2, **characterized in that**
- the first wafer (10) and the second wafer (20) are conditioned at a seventh temperature (T7) close to the eutectic temperature (TE) in step (e) and are kept at the seventh temperature (T7) until step (d).

5. Method for eutectically bonding wafers according to one of the preceding Claims 1 to 4, **characterized in that**
- the first wafer (10) having the first bonding layer (310) is provided in step (a), wherein the first bonding layer (310) is arranged in a bonding region (100) and in a supporting region (200);
- the second wafer (20) having the second bonding layer (320) is provided in step (a), wherein the second bonding layer (320) is arranged in the bonding region (100) and in the supporting region (200), wherein the spacer (400) is arranged in the supporting region;
- the process of pressing the first wafer (10) and the second wafer (20) against one another until the first bonding layer (310) comes to rest on the second bonding layer (320) takes place both in the bonding region (100) and also in the supporting region (200) in step (c);
- the eutectic (350) is formed both in the bonding region (100) and also in the supporting region (200) and in particular the spacer (400) sinks into the eutectic (350) in step (d).

6. Method for eutectically bonding wafers according to one of the preceding Claims 1 to 4, **characterized in that**
- the first wafer (10) having the first bonding layer (310) is provided in step (a), wherein the first bonding layer (310) is arranged in a bonding region (100) and in a supporting region (200);
- the second wafer (20) having the second bonding layer (320) is provided in step (a), wherein the second bonding layer (320) is arranged in the bonding region (100), wherein the spacer (400) is arranged in the supporting region;
- the process of pressing the first wafer (10) and the second wafer (20) against one another until the first bonding layer (310) comes to rest on the second bonding layer (320) takes place in the bonding region (100) in step (c); and
- the eutectic (350) is formed in the bonding region (100) and in particular the spacer (400) is pressed into the first bonding layer (310) in step (d).

## Revendications

1. Procédé de liaison eutectique de plaquettes, comprenant les étapes consistant à :
(a) fournir une première plaquette (10) dotée d'une première couche de liaison (310) et une deuxième plaquette (20) dotée d'une deuxième couche de liaison (320) et d'un espaceur (400), l'espaceur (400) ayant alors une épaisseur de couche supérieure à la couche de liaison (320),
(b) juxtaposer la première plaquette (10) contre la deuxième plaquette (20), l'espaceur (400) étant adjacent à la première couche de liaison (310), à une première température (T1),
(c) presser la première plaquette (10) et la deuxième plaquette (20) l'une contre l'autre à l'aide d'une force de pression (500) jusqu'à ce que la première couche de liaison (310) soit adjacente à la deuxième couche de liaison (320), l'espaceur (400) pénétrant dans la première couche de liaison (310),
(d) lier de manière eutectique la première plaquette (10) à la deuxième plaquette (20) en formant un système eutectique (350) au moins à partir de certaines parties de la première couche de liaison (310) et de la deuxième couche de liaison (320) et former ainsi une plaquette combinée.

2. Procédé de liaison eutectique de plaquettes selon la revendication 1, **caractérisé en ce qu'**après l'étape (b) et avant l'étape (c), dans une étape (e), la première plaquette (10) et la deuxième plaquette (20) sont trempées à une température (T4, T7) proche d'une température eutectique (TE).

3. Procédé de liaison eutectique de plaquettes selon la revendication 2, **caractérisé en ce que**
- à l'étape (e), la première plaquette (10) et la deuxième plaquette (20) sont trempées à une quatrième température (T4) proche de la température eutectique (TE), et
- ensuite, la première plaquette (10) et la deuxième plaquette (20) sont refroidies à une cinquième température (T5) qui est inférieure à la quatrième température (T4) mais supérieure à la première température (T1).

4. Procédé de liaison eutectique de plaquettes selon la revendication 2, **caractérisé en ce que**
- à l'étape (e), la première plaquette (10) et la deuxième plaquette (20) sont trempées à une septième température (T7) proche de la température eutectique (TE), et sont maintenues à la septième température (T7) jusqu'à l'étape (d).

5. Procédé de liaison eutectique de plaquettes selon l'une quelconque des revendications précédentes 1 à 4, **caractérisé en ce que**
- à l'étape (a), la première plaquette (10) avec la première couche de liaison (310) est fournie, la première couche de liaison (310) étant disposée dans une zone de liaison (100) et dans une zone d'appui (200) ;
- à l'étape (a), la deuxième plaquette (20) avec la deuxième couche de liaison (320) est fournie, la deuxième couche de liaison (320) étant disposée dans la zone de liaison (100) et dans la zone d'appui (200), l'espaceur (400) étant disposé dans la zone d'appui ;
- à l'étape (c), la pression de la première plaquette (10) et de la deuxième plaquette (20) l'une contre l'autre jusqu'à ce que la première couche de liaison (310) soit adjacente à la deuxième couche de liaison (320) est effectuée à la fois dans la zone de liaison (100) et dans la zone d'appui (200) ;
- à l'étape (d), le système eutectique (350) est formé à la fois dans la zone de liaison (100) et dans la zone d'appui (200), et en particulier, l'espaceur (400) s'enfonce dans le système eutectique (350).

6. Procédé de liaison eutectique de plaquettes selon l'une quelconque des revendications précédentes 1 à 4, **caractérisé en ce que**
- à l'étape (a), la première plaquette (10) avec la première couche de liaison (310) est fournie, la première couche de liaison (310) étant disposée dans une zone de liaison (100) et dans une zone d'appui (200) ;
- à l'étape (a), la deuxième plaquette (20) avec la deuxième couche de liaison (320) est fournie, la deuxième couche de liaison (320) étant disposée dans la zone de liaison (100), l'espaceur (400) étant disposé dans la zone d'appui ;
- à l'étape (c), la pression de la première plaquette (10) et de la deuxième plaquette (20) l'une contre l'autre jusqu'à ce que la première couche de liaison (310) soit adjacente à la deuxième couche de liaison (320) est effectuée dans la zone de liaison (100) ; et
- à l'étape (d), le système eutectique (350) est formé dans la zone de liaison (100), et en particulier l'espaceur (400) est pressé dans la première couche de liaison (310).
